# EUROPÄISCHE PATENTSCHRIFT

(11) **EP 1 158 075 B1**
(45) Veröffentlichungstag und Bekanntmachung des Hinweises auf die Patenterteilung: **14.08.2002**
(21) Anmeldenummer: 01110124.3
(22) Anmeldetag: 03.05.2001
(51) Int. Cl.: C30B 15/22, C30B 15/00, C30B 29/06

(54) **Einkristallstab und Verfahren zur Herstellung desselben**
Single crystal ingot and its method of production
Lingot monocristallin et son procédé de fabrication

(30) Priorität: 25.05.2000 DE 10025870
(43) Veröffentlichungstag der Anmeldung: 28.11.2001
(73) Patentinhaber: Wacker Siltronic Gesellschaft für Halbleitermaterialien Aktiengesellschaft, 84489 Burghausen (DE)
(72) Erfinder: Weber, Martin, Dr., 84556 Kastl (DE); Gmeilbauer, Erich, 5120 St. Pantaleon (AT); Vorbuchner, Robert, 84489 Burghausen (DE); Miller, Alfred, Dr., 84547 Emmerting (DE)
(74) Vertreter: Rimböck, Karl-Heinz, Dr.

(56) Entgegenhaltungen:
- EP-A- 0 142 415
- EP-A- 0 482 438
- JP-A- 5 957 987
- US-A- 4 299 651
- US-A- 4 586 979
- PATENT ABSTRACTS OF JAPAN vol. 014, no. 146 (C-0704), 20. März 1990 (1990-03-20) & JP 02 018396 A (TOSHIBA CORP), 22. Januar 1990 (1990-01-22)
- PATENT ABSTRACTS OF JAPAN vol. 8, no. 156 (C-234) [1593], 19. Juli 1984 (1984-07-19) & JP 59 057987 A (SUMITOMO), 3. April 1984 (1984-04-03)

## Beschreibung

Die Erfindung betrifft ein Verfahren zur Herstellung von versetzungsfreien Einkristallstäben aus Silicium nach dem CZ-Tiegelziehverfahren, wobei ein Impfkristall in eine Schmelze eingetaucht und wieder herausgezogen wird.

Für die Herstellung hochreiner Einkristallstäbe, insbesondere einkristalliner Siliciumstäbe sind das Tiegelziehverfahren nach Czochralski (CZ-Tiegelziehverfahren) und das Zonenziehverfahren bekannt geworden. Beim Tiegelziehen von Kristallstäben, insbesondere von Halbleiterstäben nach Czochralski, wird in der Regel der zur Erzeugung der Schmelze vorgesehene mono- oder polykristalline Halbleiterbruch in einem Schmelztiegel vorgelegt. Durch Beheizung wird dann die Tiegeltemperatur gesteigert, bis der Tiegelinhalt nach und nach in den geschmolzenen Zustand übergeht. An die Schmelze wird schließlich ein Impfkristall angesetzt und im allgemeinen unter Drehung von Tiegel und Kristall ein einkristalliner Kristallstab aus der Schmelze gezogen.

Dieser Kristallstab setzt sich aus dem Impfkristall, gegebenenfalls dem Impflingdünnhals, einem Kristallkonus (Anfangskonus), der sich als Übergang zu dem zylindrischen Kristallstab darstellt und dem Kristallstab zusammen. Ausführlich ist das Tiegelziehverfahren nach Czochralski z. B. in W. Zulehner und D. Huber, Czochralski-Grown Silicon, Crystals 8, Springer Verlag, Berlin-Heidelberg, 1982, und der dort zitierten Literatur, unter besonderer Berücksichtigung des derzeit wichtigsten Anwendungsgebietes, nämlich des Tiegelziehens von Siliciumeinkristallen, erläutert.

Ein Verfahren und eine Vorrichtung zur Kontrolle des Kristallwachstums im Bereich des Anfangskonus mit dem Ziel, einen möglichst kurzen, d. h. stumpfwinkligen Anfangskonus zu ziehen, ist in EP 482 438 A1 beschrieben.

Bei der Herstellung von Einkristallstäben treten häufig Kristallversetzungen im Übergangsbereich vom Kristallkonus, dem Anfangskonus, zum zylindrischen Stabteil auf, die diesen Kristallstab unbrauchbar machen. Insbesondere bei dotiertem Silicium, insbesondere bei mit As oder Sb dotiertem Silicium treten diese Kristallversetzungen auf. Der gezogene Stab muß zurückgeschmolzen werden und ein erneuter, aufwendiger Ziehversuch gestartet werden. Die Zahl der Ziehversuche ist jedoch beispielsweise durch die Standzeit des Schmelztiegels begrenzt, so daß kein defektfreier Einkristall mehr gezogen werden kann.

Die Aufgabe der Erfindung lag daher in der Bereitstellung eines defektfreien Einkristallstabes und eines Verfahrens zur Herstellung desselben.

Gelöst wird die Aufgabe durch einen Einkristallstab aus Silicium, erhalten nach dem CZ-Tiegelziehverfahren, im wesentlichen umfassend einen Anfangskonus und einen zylindrischen Einkristallstab, der dadurch gekennzeichnet ist, daß der Anfangskonus einen Öffnungswinkel von 40 bis 60 ° aufweist.

Überraschenderweise zeigte sich, daß bei bestimmten Anfangskonen weder Kristalldefekte im Konusbereich noch im zylindrischen Stabteil auftreten. Beispielsweise sind As- und Sb-dotierte Kristallstäbe mit (100)-Orientierung mit einem spitzwinkligen, langen Konus defektfrei erhältlich. Wird der Konus des Kristalls in bestimmter Art und Weise gezogen (Spitzkonus), so zeigt sich, daß keine Kristallversetzungen mehr auftreten. Die dazu notwendigen Bedingungen sind u. a. abhängig vom Durchmesser und der Orientierung des Kristalls. Der Kristallkonus hat einen Öffnungswinkel von 40 bis 60 °.

Länge und Öffnungswinkel des Kristallkonus werden beispielsweise mittels Schmelztiegel- und/oder Kristallrotation, Temperatur der Schmelze und insbesondere mittels der Kristallhubgeschwindigkeit variiert.

Demnach wird die Aufgabe auch gelöst durch ein Verfahren zur Herstellung von versetzungsfreien Einkristallstäben aus Silicium nach dem CZ-Tiegelziehverfahren, wobei ein Impfkristall in eine Schmelze eingetaucht und wieder herausgezogen wird, das dadurch gekennzeichnet ist, daß ein Kristallstab mit einem Anfangskonus mit einem Öffnungswinkel von 40 bis 60 ° gezogen wird.

Überraschenderweise zeigte sich, daß insbesondere bei hohen Dotierstoffmengen, insbesondere bei As- und Sb-dotiertem Schmelzenmaterial, spezielle Ziehvorgaben für den Anfangskonusbereich des Kristalls notwendig sind, um einen defektfreien Kristallstab zu erhalten.

In einer weiteren Ausführungsform des erfindungsgemäßen Verfahren wird zunächst ein Dünnhals und anschließend ein Kristallkonus mit einem Öffnungswinkel von 40 bis 60 ° gezogen.

Das Kristallwachstum, insbesondere das Konuswachstum wird dabei bevorzugt durch die Kristallhubgeschwindigkeit und durch Schmelztiegel- und/oder Kristalldrehungen eingestellt. Die Kristallhubgeschwindigkeit beträgt bevorzugt von 0,5 bis 2 mm/min und besonders bevorzugt von 1 bis 1,5 mm/min. Die Schmelztiegeldrehung beträgt bevorzugt von 0 bis 20 U/min und besonders bevorzugt von 5 bis 15 U/min. Die Kristalldrehung beträgt bevorzugt von 10 bis 30 U/min und besonders bevorzugt von 15 bis 20 U/min.

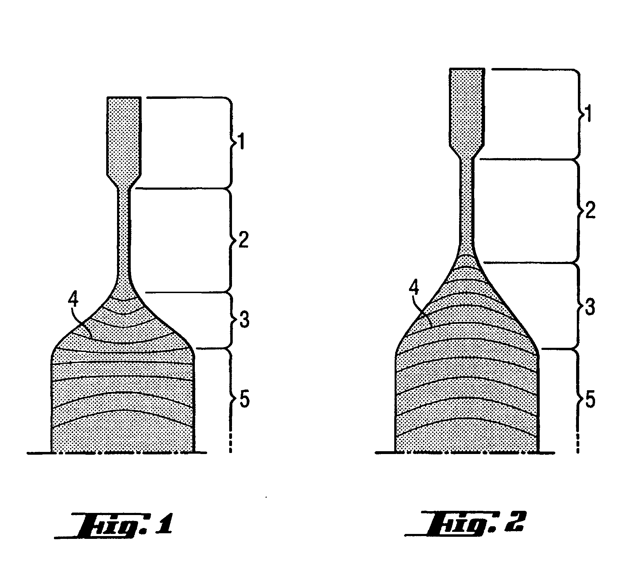

Figur 1 zeigt einen Kristallstab gemäß dem Stand der Technik, erhalten nach dem CZ-Tiegelziehverfahren, mit einem Impfkristallbereich (1), einem Dünnhalsbereich (2), einem flachen, kurzen Kristallkonus (3) und dem zylindrischen Kristallstab (5) sowie die Kristallwachstumsfront (4). Ein derartiger Flachkonus weist eine konkave Wachstumsfront auf. Beim Übergang zum zylindrischen Stabbereich beobachtet man eine Änderung der Krümmung der Kristallwachstumsfront (4) (vgl. Fig. 1). Durch den Wechsel der Erstarrungsfront tritt ein Nullwachstum im Inneren des Kristalls auf. Es ist anzunehmen, daß dadurch gehäuft Siliciumzwischengitteratome auftreten, die wiederum kleine Versetzungsschleifen ausbilden. Andererseits treten gerade im Kristallzentrum die höchsten Dotierstoffkonzentrationen auf, die Gitterspannungen erzeugen. Im Zusammenwirken mit den Versetzungsschleifen und den thermischen Spannungen bei großen Kristalldurchmessern, beispielsweise bei Durchmessern von 100 bis 400 mm, können Versetzungen entstehen, die sich im Kristall ausbreiten und ihn unbrauchbar machen.

Figur 2 zeigt einen erfindungsgemäßen Kristallstab, erhalten nach dem erfindungsgemäßen Verfahren, mit einem Impfkristallbereich (1), einem Dünnhalsbereich (2), einem langen, spitzwinkligen Kristallkonus (3) und dem zylindrischen Kristallstab (5) sowie die Kristallwachstumsfront (4). Der lange, spitzwinklige Kristallkonus zeichnet sich dadurch aus, daß kein Wechsel der Wachstumsfront stattfindet. Bereits im Konus hat die Erstarrungsfront die gleiche Krümmung wie im zylindrischen Stabteil (Fig. 2).

Vorteilhaft an dem erfindungsgemäßen Kristallstab ist neben der Versetzungsfreiheit auch, daß der gesamte zylindrische Bereich des Kristallstabes zur Herstellung von Halbleiterscheiben verwendet werden kann, da sich die gewünschten Qualitätseigenschaften schon am Anfang des zylindrischen Stabteils einstellen. Das erfindungsgemäße Verfahren zur Herstellung von versetzungsfreien Einkristallstäben eignet sich besonders für hochdotierte Kristalle mit (100)-Orientierung. Der erfindungsgemäße Kristallstab hat weder Kristallversetzungen im Bereich des Kristallkonus noch im Bereich des zylindrischen Stabteils.

Zur Durchführung des Verfahrens zur Herstellung von versetzungsfreien Einkristallstäben wird zunächst ein Impfkristall (1) in eine Siliciumschmelze getaucht und langsam unter Rotation herausgezogen. Gegebenenfalls wird zur Vermeidung von Versetzungen zunächst ein Dünnhals (2) gezogen. Dann folgt der konusförmige Übergang (3) in den zylindrischen Stabteil (5). Aus letzterem werden die Halbleiterscheiben gewonnen. Insbesondere bei hochdotierten Kristallen treten im Kristallkonus und im Übergangsbereich zum zylindrischen Stabteil Versetzungen auf, die den Kristall unbrauchbar machen. In diesem Fall wird der bereits gezogene Teil des Einkristalls zurückgeschmolzen und ein neuer Ziehversuch mit
Temperaturstabilisierung und Eintauchen des Impfkristalls begonnen. Die erneuten Ziehversuche erfordern einen großen Zeitaufwand. Dabei wird unter anderem der Quarzglastiegel so sehr beansprucht, daß sich Quarzpartikel ablösen, die wiederum Kristallversetzungen auslösen. Mit jedem Ziehversuch wird daher die Wahrscheinlichkeit geringer einen brauchbaren Siliciumstab zu ziehen. Wird statt des üblichen flachen, kurzen Kristallkonuses ein spitzwinkliger, langer Kristallkonus gezogen, so treten weder Versetzungen im Konusbereich noch im zylindrischen Stabteil auf.

### Beispiele

In den nachfolgenden Beispielen wurden Kristallstäbe mit Spitzkoni mit öffnungswinkeln unter 90° gezogen. Es wurde ein Kristallhub von >1 mm/min, Kristalldrehungen unter 15 U/min, Tiegeldrehungen unter 20 U/min und eine angpaßte Heizerleistung benutzt. Der spezifische Widerstand der arsen- bzw. antimondotierten, (100)-orientierten Kristalle lag bei unter 5 mOhmcm bzw. unter 25 mOhmcm.

| **Kristalldurchmesser** | **Dotierung** | **Mittlere Anzahl der Ziehversuche mit Standardkonus** | **Mittlere Anzahl der Ziehversuche mit Spitzkonus** |
|---|---|---|---|
| 5" | As | 2.5 | 1.5 |
| 6" | As | 3.0 | 2.0 |
| 8" | As | 4.5 | 2.5 |
| 5" | Sb | 3.0 | 2.0 |
| 6" | Sb | 4.0 | 2.5 |
| 8" | Sb | 4.5 | 2.5 |

In der folgenden Tabelle ist die Verringerung der Ziehversuche am Beispiel eines niederohmigen Arsenprozesses anhand einer statistischen Auswertung dargestellt. Die für die Ziehversuche benötigte Gesamtzeit wird dabei als Ansetzzeit (AZ) bezeichnet. Die statistische Auswertung zeigt eine signifikante Verringerung der Ansetzzeit durch Verwendung von Spitzkonen.

| | **Standardkonus** | **Spitzkonus** |
|---|---|---|
| Anzahl der Versuche | 18 | 14 |
| Mittlere Ansetzzeit | 991 min | 593 min |
| Median | 1093 min | 425 min |
| Maximum | 1595 min | 1480 min |
| Minimum | 285 min | 215 min |
| Standardabweichung | 376 min | 411 min |

## Patentansprüche

1. Einkristallstab aus Silicium, erhalten nach dem CZ-Tiegelziehverfahren, im wesentlichen umfassend einen Anfangskonus und einen zylindrischen Einkristallstab, **dadurch gekennzeichnet, daß** der Anfangskonus einen Öffnungswinkel von 40 bis 60 ° aufweist.

2. Einkristallstab gemäß Anspruch 1, **dadurch gekennzeichnet, daß** der Kristallstab eine Dotierung aufweist.

3. Verfahren zur Herstellung von versetzungsfreien Einkristallstäben aus Silicium nach dem CZ-Tiegelziehverfahren, wobei ein Impfkristall in eine Schmelze eingetaucht und wieder herausgezogen wird, **dadurch gekennzeichnet, daß** ein Kristallstab mit einem Anfangskonus mit einem Öffnungswinkel von 40 bis 60 ° gezogen wird.

4. Verfahren gemäß Anspruch 3, **dadurch gekennzeichnet, daß** der Öffnungswinkel des Anfangskonus mittels Schmelztiegel- und/oder Kristallrotation, Temperatur der Schmelze und mittels der Kristallhubgeschwindigkeit eingestellt wird.

## Claims

1. Single-crystal rod made of silicon, obtained using the CZ crucible pulling process, substantially comprising a starting cone and a cylindrical single-crystal rod, **characterized in that** the starting cone has an apex angle of 40 to 60°.

2. Single-crystal rod according to Claim 1, **characterized in that** the crystal rod has a doping.

3. Process for producing dislocation-free single-crystal rods made of silicon using the CZ crucible pulling process, in which a seed crystal is immersed in a melt and is pulled out again, **characterized in that** a crystal rod having a starting cone with an apex angle of from 40 to 60° is pulled.

4. Process according to Claim 3, **characterized in that** the apex angle of the starting cone is set by means of rotation of the melt crucible and/or rotation of the crystal, the temperature of the melt and by means of the crystal-lifting rate.

## Revendications

1. Tige de monocristal en silicium, obtenu conformément au procédé d'étirage en creuset Czochralski, comprenant pour l'essentiel un cône de départ et une tige de monocristal cylindrique, **caractérisée en ce que** le cône de départ présente un angle d'ouverture de 40 à 60°.

2. Tige de monocristal selon la revendication 1, **caractérisée en ce que** la tige de cristal présente un dopage.

3. Procédé en vue de la fabrication de tiges de monocristaux exempts de dislocation en silicium conformément au procédé d'étirage en creuset Czochralski, un cristal de vaccination étant immergé dans la masse fondue et étant toujours à nouveau retiré de celle-ci, **caractérisé en ce que** l'on tire une tige de cristal ayant un cône de départ avec un angle d'ouverture de 40 à 60°.

4. Procédé selon la revendication 3, **caractérisé en ce que** l'angle d'ouverture du cône de départ est réglé par l'intermédiaire de la rotation du creuset de fusion et/ou du cristal, de la température de la masse fondue et de la vitesse de la course du cristal.
